# EUROPÄISCHE PATENTSCHRIFT

(11) **EP 2 880 724 B1**
(45) Veröffentlichungstag und Bekanntmachung des Hinweises auf die Patenterteilung: **17.05.2023**
(21) Anmeldenummer: 13741755.6
(22) Anmeldetag: 25.07.2013
(51) Int. Cl.: H01S 5/06, H01S 5/068, H01S 5/00, B60Q 1/00, B60Q 11/00, F21S 41/16, F21S 41/176, F21S 41/60, H05B 45/00, H05B 47/00

(54) **STEUERVORRICHTUNG ZUR ANSTEUERUNG EINER LASERDIODE**
CONTROL DEVICE FOR CONTROLLING A LASER DIODE
DISPOSITIF DE COMMANDE POUR COMMANDER UNE DIODE LASER

(30) Priorität: 02.08.2012 DE 102012213670
(43) Veröffentlichungstag der Anmeldung: 10.06.2015
(73) Patentinhaber: Bayerische Motoren Werke Aktiengesellschaft, 80809 München (DE)
(72) Erfinder: WERKSTETTER, Mario, 80809 München (DE)
(86) Internationale Anmeldenummer: PCT/EP2013/065725
(87) Internationale Veröffentlichungsnummer: WO 2014/019934

(56) Entgegenhaltungen:
- EP-A1- 1 624 543
- EP-A2- 0 431 832
- JP-A- 2010 103 293
- US-A1- 2001 036 211
- US-A1- 2006 182 158
- US-A1- 2006 291 510
- US-A1- 2010 001 659
- US-A1- 2011 063 115
- US-A1- 2011 280 032

## Beschreibung

Die Erfindung betrifft eine Steuervorrichtung zur Ansteuerung einer Laserdiode, insbesondere eine elektronische Schaltung zur Gewährleistung der Produktsicherheit in Fahrzeugbeleuchtungseinrichtungen mit einer Laserdiode. Des Weiteren betrifft die Erfindung eine Beleuchtungsvorrichtung für ein Fahrzeug sowie ein Fahrzeug mit einer derartigen Beleuchtungsvorrichtung.

US 2006/291510 A1 offenbart eine Steuerschaltung zur Steuerung einer Laserquelle. Die Steuerschaltung weist dazu eine Laser-Treiberschaltung auf, die ausgangsseitig einen Steuerstrom aus einem AC-Signalanteil und einem DC-BIAS-Strom erzeugt. Der AC- und der DC-Stromanteil stellen einen Treiberstrom für die Laserquelle dar. Der Pegel des DC-BIAS-Stromanteils wird von einer Monitorschaltung ermittelt und nach Analog/Digitalwandlung als Eingangsgröße einem Prozessor zugeführt. Der Prozessor erzeugt unter anderem ausgangsseitig ein Steuersignal zur Einstellung des DC-BIAS-Stroms, das der Laser-Treiberschaltung zugeführt wird.

Laserdioden lösen in zunehmendem Maße bislang in Fahrzeugscheinwerfern verwendete Lichtquellen, wie beispielsweise Leuchtdioden (LEDs), Xenon-Lampen oder Glühlampen, ab. Die für die herkömmlichen Leuchtmittel verwendeten Steuereinheiten sind für die elektrische Ansteuerung von Laserdioden nicht geeignet. Die elektrischen und thermischen Eigenschaften von Halbleiterlasern erfordern eine eigens dafür entwickelte Steuerelektronik und -logik. Laserdioden benötigen zur Ansteuerung zwingend eine vorgeschaltete Elektronik, die die spezifischen Eigenschaften dieses Leuchtmittels berücksichtigt, um eine korrekte und wertige Darstellung der damit abzubildenden Lichtfunktionen unter den im Fahrzeug gegebenen Betriebsbedingungen über die Lebensdauer gewährleisten zu können. Ohne automotive-qualifizierte Steuerelektronik können die neuartigen Laserdioden nicht im Fahrzeug zu Beleuchtungszwecken betrieben und in das Fahrzeugbordnetz integriert werden.

Aufgrund der im System vorhandenen Laserstrahlung, die bei unkontrolliertem Austritt schwere Verletzungen verursachen kann, sind aktive Maßnahmen zur Sicherstellung der Produktsicherheit unter allen Betriebsbedingungen und Fehlerfällen notwendig. Insbesondere für den Einsatz von Lichtquellen, die einer Laserklasseneinstufung >1 unterliegen, sind zusätzliche Maßnahmen notwendig, um eine Gefährdung von Menschen und sonstigen Lebewesen durch ungewollt austretende Laserstrahlung zu vermeiden.

Es ist wünschenswert, eine Steuervorrichtung zur Ansteuerung einer Laserdiode anzugeben, mit der es ermöglicht wird, die Laserdiode sicher und zuverlässig zu betreiben. Des Weiteren soll eine Beleuchtungsvorrichtung für ein Fahrzeug angegeben werden, mit der es ermöglicht wird eine Laserdiode sicher und zuverlässig zu betreiben. Ferner soll ein Fahrzeug mit einer derartigen Beleuchtungsvorrichtung angegeben werden.

Eine Ausführungsform einer Steuervorrichtung zur Ansteuerung einer Laserdiode ist im Patentanspruch 1 angegeben. Demnach umfasst die Steuervorrichtung einen Ausgangsanschluss zum Anschließen der Laserdiode, eine Regelungseinrichtung zum Erzeugen eines Ausgangssignals an einem Anschluss der Regelungseinrichtung, eine Detektoreinrichtung, die dazu ausgebildet ist, eine Regelungsgröße zu ermitteln, wenn die Regelungseinrichtung an dem Anschluss das Ausgangssignal bereitstellt und an dem Ausgangsanschluss der Steuervorrichtung die Laserdiode angeschlossen ist. Des Weiteren umfasst die Steuervorrichtung eine Rechnereinrichtung zum Bereitstellen eines Steuersignals für die Regelungseinrichtung. Die Rechnereinrichtung stellt das Steuersignal unabhängig von der Regelungsgröße bereit. Die Regelungseinrichtung ist derart ausgebildet, dass sie in Abhängigkeit von dem Steuersignal und der ermittelten Regelungsgröße einen Pegel des Ausgangssignals erzeugt.

Eine Ausführungsform einer Beleuchtungsvorrichtung für ein Fahrzeug ist im Patentanspruch 11 angegeben. Die Beleuchtungsvorrichtung umfasst eine Laserdiode und eine Steuervorrichtung zur Ansteuerung der Laserdiode nach der oben angegebenen Ausführungsform. Die Laserdiode ist an den Ausgangsanschluss der Steuervorrichtung angeschlossen.

Eine Ausführungsform eines Fahrzeugs mit einer derartigen Beleuchtungsvorrichtung ist im Patentanspruch 15 spezifiziert.

Mittels der angegebenen Steuervorrichtung kann eine geregelte Ansteuerung von Laserdioden in Fahrzeugbeleuchtungseinrichtungen sichergestellt werden. Helligkeit, Farbtemperatur und Temperatur sind dabei kontrollierbar. Spezifische Eigenschaften von Laserdioden, beispielsweise unterschiedliche Helligkeitsklassen, lassen sich auf gewünschte Zielwerte angleichen. Durch eine elektrische und thermische Begrenzung kann die Lebensdauer der Laserdioden gesteuert werden, so dass eine Auslegung auf die Fahrzeuglebensdauer möglich ist.

Die angegebene Steuervorrichtung ist ohne Einschränkung auch für den Betrieb von konventionellen, das heißt spontan emittierenden LEDs geeignet. Dadurch können Hybridscheinwerfer mit Laserdioden und Leuchtdioden angesteuert und diagnostiziert werden. Einige Lichtfunktionen im Automotive-Bereich unterliegen einer Funktionssicherheitsklassifizierung (ASIL-Level). Der Entwicklungsprozess, insbesondere die Hard- und Softwareentwicklung, muss deshalb im Allgemeinen gemäß einem Standard, beispielsweise gemäß ISO 26262, erfolgen.

Die Erfindung wird im Folgenden anhand von Figuren, die Ausführungsbeispiele der vorliegenden Erfindung zeigen, näher erläutert. Es zeigen:
- Figur 1: ein Fahrzeug mit einer Beleuchtungsvorrichtung mit einem Laserdioden-Modul,
- Figur 2: eine Ausführungsform einer Beleuchtungsvorrichtung mit einem Laserdioden-Modul und einer Steuerschaltung zur Ansteuerung einer Laserdiode.

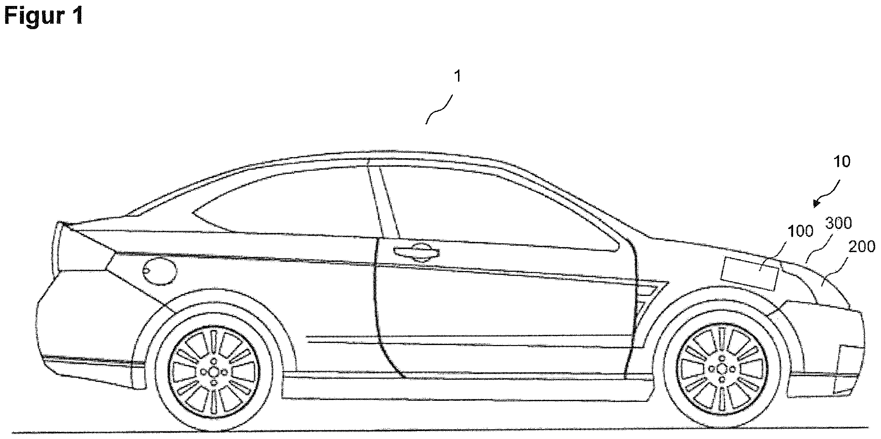

Figur 1 zeigt ein Fahrzeug 1 mit einer Beleuchtungsvorrichtung 10. Die Beleuchtungsvorrichtung 10 umfasst eine Steuervorrichtung 100, ein Laserdioden-Modul 200 mit mindestens einer und vorzugsweise mit einer Vielzahl von Laserdioden. Das Laserdioden-Modul ist in einem Scheinwerfer beziehungsweise einem Scheinwerfergehäuse 300 des Fahrzeugs 1 angeordnet. Die Laserdioden können als Halbleiter-Laserdioden ausgeführt sein. Zum Betreiben der Halbleiter-Laserdioden zur Darstellung verschiedener statischer und dynamischer Lichtfunktionen in dem Kraftfahrzeug 1 ist das Laserdioden-Modul mit der Steuervorrichtung 100 der Beleuchtungsvorrichtung 10 gekoppelt. Die Steuervorrichtung 100 kann als eine elektronische Steuereinheit oder als ein elektronisches Steuergerät zur geregelten Ansteuerung der Laserdioden des Laserdioden-Moduls ausgebildet sein. Die Steuervorrichtung 100 ist aus Gründen der elektromagnetischen Verträglichkeit und der aufwändigere Verkabelung möglichst nahe an dem Laserdioden-Modul und somit am oder im Scheinwerfer 300 verbaut.

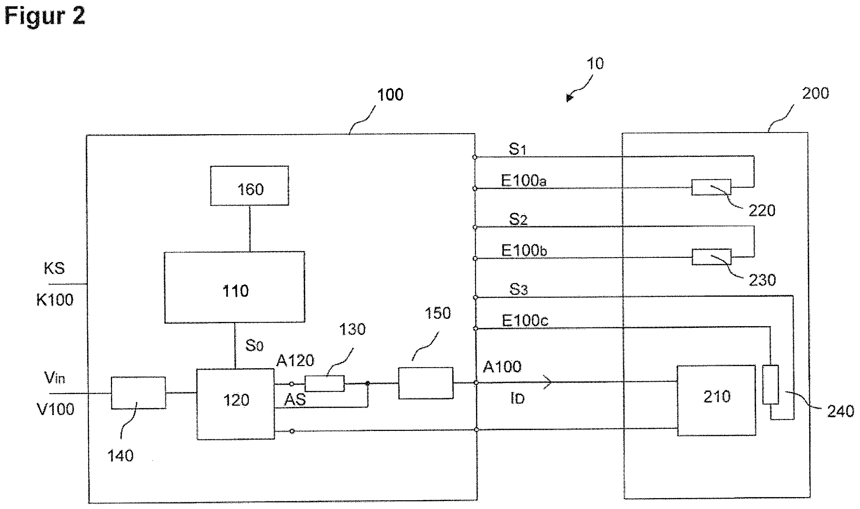

Figur 2 zeigt eine Ausführungsform der Beleuchtungsvorrichtung 10 mit der Steuervorrichtung 100 und dem Laserdioden-Modul 200. Das Laserdioden-Modul weist mindestens eine Laserdiode 210, die mit einem Ausgangsanschluss A100 der Steuervorrichtung gekoppelt ist, auf. Die Steuervorrichtung 100 umfasst im Wesentlichen einen Logik-und einen Leistungsteil. Der Leistungsteil kann beispielsweise eine Regelungseinrichtung 120 zum Erzeugen eines Ausgangssignals beziehungsweise einer Stellgröße AS an einem Anschluss A120 umfassen. Der Leistungsteil kann beispielsweise mehrere DC/DC-Schaltregler, die als Stromtreiber konfiguriert sind, aufweisen. Jede Treiberstufe kann ein Laserdioden-Modul betreiben. Die Treiberstufen können die Laserdioden sowohl im kontinuierlichen Modus als auch gepulst beziehungsweise durch Pulsweitenmodulation getaktet betreiben. Dies ermöglicht das variable Dimmen des emittierten Lichtstroms, womit dynamische und adaptive, insbesondere fahrzeug- oder umgebungsabhängige, Lichtfunktionen dargestellt werden können. Der Logikteil kann beispielsweise eine Rechnereinrichtung 110 zum Bereitstellen eines Steuersignals SO für die Regelungseinrichtungen 120 umfassen.

Des Weiteren umfasst die Steuervorrichtung 100 eine Detektoreinrichtung 130, die dazu ausgebildet ist, eine Regelungsgrö-ße ID zu ermitteln, wenn die Regelungseinrichtung 120 an dem Anschluss A120 das Ausgangssignal AS bereitstellt und an den Ausgangsanschluss A100 die Laserdiode 210 angeschlossen ist. Die Regelungseinrichtung 120 ist derart ausgebildet, dass sie in Abhängigkeit von dem Steuersignal SO und der ermittelten Regelungsgröße ID einen Pegel des Ausgangssignals AS erzeugt. Die Regelungsgröße ID ist der durch die Laserdiode 210 fließende Diodenstrom. Das Ausgangssignal beziehungsweise die Stellgröße AS kann eine Ausgangsspannung, die am Anschluss A120 von der Regelungseinrichtung 120 erzeugt wird, sein. Wenn die Regelungseinrichtung als ein Schaltregler ausgebildet ist, kann das Ausgangssignal, das die Stellgröße darstellt, eine Schaltzeit eines oder mehrerer Transistoren des Schaltreglers sein. In Abhängigkeit von der Stellgröße stellt sich an dem Ausgangsanschluss A100 der Steuervorrichtung der Ausgangs- beziehungsweise Diodenstrom ID ein.

Die Steuervorrichtung 100 kann über Schnittstellen K100, V100 mit dem Fahrzeugbordnetz verbunden sein. Im Ausführungsbeispiele der Figur 1 empfängt die Steuervorrichtung 100 an einem Kommunikationsanschluss K100 beispielsweise Kommandosignale KS und an einem Versorgungsspannungsanschluss V100 eine Versorgungsspannung Vin. Über die an dem Kommunikationsanschluss K100 zugeführten Kommandosignale können beispielsweise verschiedene Funktionen des Laserdioden-Moduls 200 aktiviert werden. Beispielsweise erhält die Steuervorrichtung 100 über die Kommandosignale KS Informationen, welche Lichtfunktionen am Laserdioden-Modul 200 einzuschalten sind. Des Weiteren wird über die an den Kommunikationsanschluss K100 angeschlossenen Busleitungen von der Steuervorrichtung 100 eine Diagnosemeldung an ein weiteres Steuergerät, das an den Kommunikationsanschluss K100 angeschlossen ist, zurück gesendet.

Die Rechnereinrichtung 110 kann als ein Microcontroller, der die funktionale Steuerung des Leistungsteils, insbesondere der Regelungseinrichtung 120, sowie dessen Parametrisierung übernimmt, ausgebildet sein. Das Steuersignal SO wird von der Rechnereinrichtung 110 beispielsweise in Abhängigkeit von dem Kommandosignal KS erzeugt. Das Steuersignal S0 enthält für die Regelungseinrichtung 120 eine Information, mit welchem Pegel der Diodenstrom ID von der Regelungseinrichtung 120 bereitgestellt werden soll. Mittels des Steuersignals SO lassen sich von der Rechnereinrichtung 110 Betriebsgrößen des Laserdioden-Moduls, beispielsweise der Sollstrom durch die Laserdioden, eine PWM(Puls-Weiten-Modula-tions)-Frequenz und ein PWM-Tastverhältnis einstellen. Das Steuersignal S0 gibt einen Soll-Pegel des Diodenstroms ID vor. In Abhängigkeit von dem Steuersignal S0 erzeugt die Regelungseinrichtung 120 an dem Anschluss A120 das Ausgangssignal beziehungsweise die Stellgröße AS.

In Abhängigkeit von dem Pegel des Ausgangssignals AS und einem Betriebszustand der Laserdiode 210 stellt sich am Ausgangsanschluss A100 ein Ist-Pegel des Diodenstroms ID ein. Der Diodenstrom ID bildet die eigentliche Regelungsgröße. Der Ist-Pegel des Diodenstroms wird von der Detektoreinrichtung 130 ermittelt. Die Detektoreinrichtung 130 kann beispielsweise ein Stromsensor, der im Strompfad zum Laserdioden-Modul angeordnet ist, sein. Die Regelungseinrichtung 120 ist dazu ausgebildet, den Ist-Pegel des Diodenstroms mit dem von der Rechnereinrichtung 110 durch das Steuersignal S0 vorgegebenen Soll-Pegel des Diodenstroms zu vergleichen und das Ausgangssignal beziehungsweise die Stellgröße AS entsprechend zu verändern, wenn sich der Soll-Pegel des Diodenstroms vom Ist-Pegel unterscheidet.

Die Detektoreinrichtung 130 kann zum Ermitteln eines über den Ausgangsanschluss A100 fließenden Pegels eines Ausgangsstroms beziehungsweise Diodenstroms ID ausgebildet sein. Die Detektoreinrichtung ist zwischen dem Ausgangsanschluss A100 und der Regelungseinrichtung 120 angeordnet. Die Detektoreinrichtung 130 kann beispielsweise einen Widerstand, der mit dem Anschluss A120 der Regelungseinrichtung 120 verbunden ist, aufweisen. An dem Widerstand kann beispielsweise eine Spannung abgegriffen werden. Die Regelungseinrichtung 120 kann eine Auswerteeinheit zum Ermitteln des Pegels des Ausgangsstroms ID durch Auswerten der an dem Widerstand abfallenden Spannung aufweisen.

Die Steuervorrichtung 100 unterbricht das Erzeugen des Ausgangsstroms ID, wenn der Pegel des Ausgangsstroms ID einen Schwellwert überschreitet. Die Regelungseinrichtung 120 kann beispielsweise Schaltregler-ICs enthalten, die eine elektrische Überwachung der Laserdioden und deren elektrischer Kontaktierung durchführen. Durch Überwachung des Diodenstroms ID mittels der Detektoreinrichtung 130 können Kurzschlüsse und Unterbrechungen diagnostiziert werden. Falls ein Fehlerfall diagnostiziert wird, werden definierte Zustände eingenommen. Die Steuervorrichtung 100 bewirkt beispielsweise ein sofortiges Abschalten des Lasermoduls, indem die Erzeugung des Ausgangssignals AS unterbrochen wird.

Die Steuervorrichtung 100 ist derart ausgelegt, dass die Restwelligkeit des Ausgangsstroms ID durch die Dioden 210 des Laserdioden-Moduls minimal, beispielsweise kleiner als 5 % fs (full scale) ist. Aufgrund der hohen Sensitivität der Laserdioden in Bezug auf eine elektrische Überlast, die einen hohen Strom-/Spannungsspitzenwert zur Folge haben kann und die in kürzester Zeit, beispielsweise in einigen Nanosekunden, zur Zerstörung des Laserdioden-Moduls führen kann, ist deren sichere Vermeidung eine zentrale Anforderung bei der Auswahl der Treibertopologie und der Bauteildimensionierung.

Bei der in Figur 2 gezeigten Ausführungsform der Steuervorrichtung ist zusätzlich eine Filterung zum elektrischen Fahrzeugbordnetz vorgesehen, um insbesondere transiente Spannungsänderungen in der Versorgung von den Laserdioden fernzuhalten. Dazu weist die Steuervorrichtung 100 eine Filterschaltung 140, die zum Herausfiltern von transienten Spannungsänderung der Versorgungsspannung Vin aus dem Fahrzeugbordnetz vorgesehen ist, auf. Des Weiteren kann die Steuervorrichtung 100 eine Filterschaltung 150, die zwischen die Detektoreinrichtung 130 und den Ausgangsanschluss A100 geschaltet ist, umfassen. Die Filterschaltung 150 ist dazu ausgebildet eine Strom- und Spannungswelligkeit aus dem Ausgangssignal der Regelungseinrichtung herauszufiltern.

Die Rechnereinrichtung 110 beziehungsweise ein darin enthaltener Mikroprozessor berücksichtigt bei der Erzeugung des Steuersignals SO weitere Leuchtmittel spezifische Charakteristika, welche als Kennlinie, Kennfeld oder Algorithmus in einem nichtflüchtigen Speicher hinterlegt sein können und in die Steuergröße SO beziehungsweise die damit einzustellenden Betriebsparameter mit eingerechnet werden. Die Steuervorrichtung 100 weist beispielsweise eine Speichereinrichtung 160 zum Speichern der leuchtmittelspezifischen Charakteristiken der Laserdiode 210 auf. Die Rechnereinrichtung 110 ist für einen Zugriff auf die Speichereinrichtung 160 an diese gekoppelt. Die Speichereinrichtung 160 kann beispielsweise als ein nichtflüchtiger Speicher des Steuergerätes 100 ausgebildet sein.

Die subjektive Wahrnehmung der emittierten Lichtstärke einer Laserdiode ist nicht proportional zum arithmetischen Mittelwert der elektrischen Leistung, weshalb das verwendete Helligkeitsspektrum mit Hilfe einer Kennlinie von der Rechnereinrichtung 110 korrigiert und so optisch linearisiert werden kann. Die Kennlinie kann beispielsweise ebenfalls in der Speichereinrichtung 160 abgespeichert sein. Außerdem kann in der Speichereinrichtung 160 eine Alterungscharakteristik der Laserdiode 110, die einen Zusammenhang zwischen der Abnahme des Lichtstroms über der Betriebsdauer und -temperatur enthält, hinterlegt sein. Durch Erzeugung der Steuersignals SO von der Rechnereinrichtung 110 in Abhängigkeit von der Alterungscharakteristik der Laserdiode kann gewährleistet werden, dass über die gesamte Lebensdauer des Laserdioden-Moduls ein konstanter Lichtstrom erzeugt wird.

Des Weiteren kann von der Rechnereinrichtung 110 bei der Erzeugung des Steuersignals SO eine Binningklasse der in dem Laserdioden-Modul vorhandenen Laserdiode berücksichtigt werden. Die Binningklasse kennzeichnet eine Helligkeits-und Farbsortierung der Laserdiode 210. Die zu der Laserdiode zugehörige Binningklasse kann ebenfalls in der Speichereinrichtung 160 gespeichert sein. Die in jedem spezifischen Laserdioden-Modul verbauten Binningklassen können beispielsweise während des Produktionsprozesses der Leuchte 300 per Codierung in den nichtflüchtigen Speicher 160 des Steuergerätes 100 geschrieben oder durch einen ohmsche Widerstand mit definierten Wertebereichen, welcher mit dem Laserdioden-Modul verbaut ist, vom Mikrocontroller der Rechnereinrichtung 110 eingelesen werden. Die Nivellierung der Helligkeit der unterschiedlichen Binningklassen kann von der Rechnereinrichtung 110 durch Anpassung des Tastverhältnisses der Pulsweitenmodulation vorgenommen werden. Der Farbort kann in einem eingeschränkten Bereich durch ein bei konstanter Leistung verändertes Verhältnis von Spitzenstrom und PWM- Tastverhältnis angepasst werden. Dies ist durch die für Halbleiter-Laserdioden charakteristische Drift des Farbortes über den Spitzenstrom möglich.

Die Rechnereinrichtung 110 erzeugt das Steuersignal SO in Abhängigkeit von den gespeicherten leuchtmittelspezifischen Charakteristiken, so dass die Höhe des Diodenstroms ID beziehungsweise die PWM-Frequenz und das PWM-Tastverhältnis entsprechend der leuchtmittelspezifischen Charakteristiken von der Rechnereinrichtung 110 für die Regelungseinrichtung 120 vorgegeben werden.

Die Steuervorrichtung 100 umfasst einen Eingangsanschluss E100a zum Anschließen eines Sensors 220, der zum Ermitteln einer Temperatur der Laserdiode 210 ausgebildet ist. Der Temperatursensor 220 erzeugt ein Sensorsignal S1 in Abhängigkeit von der ermittelten Temperatur der Laserdiode 210. Die Rechnereinrichtung 110 erzeugt das Steuersignal S0 in Abhängigkeit von dem Sensorsignal S1. Die Rechnereinrichtung 110 kann das Steuersignal SO beispielsweise derart erzeugen, dass die Regelungseinrichtung 120 das Erzeugen des Ausgangssignals AS unterbricht, wenn die Rechnereinrichtung 110 nach dem Auswerten des Sensorsignals S1 feststellt, dass die von dem Temperatursensor 220 ermittelte Temperatur der Laserdiode 210 über einem Schwellwert liegt.

Auf jedem Laserdioden-Modul eines Fahrzeugs kann ein Sensor zur Erfassung der Temperatur des Moduls vorgesehen sein. Unter Kenntnis der thermischen Übergangswiderstände zwischen der Position des Sensors und der Sperrschicht des Diodenkristalls und der thermischen Trägheit des Systems, wird aus dem Messwert die Sperrschichttemperatur der Laserdiode von der Rechnereinrichtung 110 berechnet. Die Sperrschichttemperatur stellt ebenfalls eine Regelgröße dar, in deren Abhängigkeit die Leistung des Laserdioden-Moduls geregelt wird. Somit kann eine Überhitzung vermieden beziehungsweise bei einem Überschreiten von in der Rechnereinrichtung 110 hinterlegten Grenztemperaturen das Laserdioden-Modul zum Schutz der Komponenten abgeschaltet werden.

Die Steuervorrichtung 100 weist einen weiteren Eingangsanschluss E100b zum Anschließen eines Sensors 230, der zum Feststellen eines bestimmungsgemäßen oder fehlerhaften Betriebszustands der Laserdiode 210 ausgebildet ist, auf. Der Eingangsanschluss ElOOb ist insbesondere zum Empfang eines von dem Sensor 230 in Abhängigkeit von dem festgestellten Betriebszustand der Laserdiode erzeugten Sensorsignals S2 ausgebildet. Die Rechnereinrichtung 110 erzeugt das Steuersignal SO in Abhängigkeit von dem Sensorsignal S2. Die Rechnereinrichtung 110 erzeugt das Steuersignal SO insbesondere derart, dass die Regelungseinrichtung 120 das Erzeugen des Ausgangssignals AS unterbricht, wenn die Rechnereinrichtung 110 nach dem Auswerten des Sensorsignals S2 feststellt, dass die Laserdiode 210 den fehlerhaften Betriebszustand aufweist.

Der weitere Sensor 230 ist somit als ein Sicherheitssensor zur Gewährleistung der gestellten Produktsicherheitsanforderungen ausgebildet, der durch die CPU 110 ausgewertet werden kann. Durch den Sensor 230 wird es ermöglicht, dass weder bei Komponentenfehlern noch bei einer Beschädigung des Lasermoduls gefährliche Laserstrahlung austreten kann. Der Sensor 230 kann beispielsweise ein elektrisch leitfähiges Material, das in mäander- oder spiralförmiger Struktur auf das gesamte Lasermodul, einschließlich eventueller Lichtleiter und der Lichtaustrittsfläche, aufgebracht ist, enthalten. Die beiden Enden des Leiters können mit dem Steuergerät 110, welches die elektrische Durchgangsfähigkeit überwacht, kontaktiert sein. Bei einem mechanischen Defekt, bei Materialversagen oder bei Beschädigung durch äußere Einwirkungen, beispielsweise durch einen Unfall, wird der elektrische Widerstand des leitfähigen Materials hochohmig. Bei Überschreiten eines Grenzwertes wird dies von der Rechnereinrichtung 110 als Fehler erkannt und das Steuersignal SO derart erzeugt, dass das betroffene Laserdioden-Modul im Sinne der Produktsicherheit abgeschaltet wird.

Durch die nicht fotobasierte Überwachung des Laserdioden-Moduls ist bereits bei ausgeschaltetem Lasermodul eine Diagnose des Moduls möglich. Der Auslesezyklus der Sensorauswertung, die Entprellzeit und die Laufzeit der Softwarereaktion sind so ausgelegt, dass die geforderte maximal zulässige Emissionszeit von Laserstrahlung, beispielsweise eine Emissionszeit kleiner als 1 ms, unterschritten wird.

Des Weiteren kann die Steuervorrichtung 100 alternativ zu dem beschriebenen Sensorkonzept der Sensoren 220 und 230 einen weiteren Sensor 240 umfassen. Die Steuervorrichtung 100 weist dazu einen Eingangsanschluss E100c zum Anschließen des Sensors 240 auf. Der Sensor 240 ist zum Erfassen des Lichtstroms der Laserdiode 210 ausgebildet. Der Sensor 240 erzeugt in Abhängigkeit von dem erfassten Lichtstrom der Laserdiode 210 ein Sensorsignal S3, das dem Eingangsanschluss E100c zugeführt wird. Die Rechnereinrichtung 110 erzeugt das Steuersignal SO in Abhängigkeit von dem Sensorsignal S3. Die Rechnereinrichtung 110 kann das Steuersignal SO derart erzeugen, dass die Regelungseinrichtung 120 das Erzeugen des Ausgangssignals AS unterbricht, wenn die Rechnereinrichtung 110 nach dem Auswerten des Sensorsignals S3 feststellt, dass der von der Laserdiode 210 erzeugte Lichtstrom über oder unter einem Grenzwert liegt und/oder die spektrale Zusammensetzung des von der Laserdiode emittierten Lichts sich in einen verbotenen Bereich befindet.

Der Sensor 240 kann beispielsweise einen fotosensitiven Widerstand enthalten. Dieser ist nahe der Lichtaustrittsfläche und eventueller Konversionsschichten der Laserdiode verbaut und dient der Erfassung der Beleuchtungsstärke der Laserdiode 210, mit welcher der gesamte emittierte Lichtstrom berechnet werden kann. Dabei ist der durch den Sensor abgedeckter Raumwinkel und die Spektralliniensensitivität zu berücksichtigen. Der Lichtstrom kann als Regelgröße für die elektrische Ansteuerung verwendet werden und ermöglicht zudem eine Überwachung der Funktionsfähigkeit des optischen Systems das heißt insbesondere eines Ausfalls oder Fehlers von Leuchtmitteln, Lichtleitern, Konvertern oder anderen verwendeten optischen Elementen. Auch bei dieser Ausführungsform wird nach Auswertung des Sensorsignals S3 im erkannten Fehlerfall von der Rechnereinrichtung 110 das Steuersignal SO derart erzeugt, dass ein von dem Fehler betroffenes Laserdioden-Modul abgeschaltet wird.

### Bezugszeichenliste

- 1: Fahrzeug
- 10: Beleuchtungsvorrichtung
- 100: Steuervorrichtung
- 110: Rechnereinrichtung
- 120: Regelungseinrichtung
- 130: Detektoreinrichtung
- 140: Filterschaltung
- 150: Filterschaltung
- 160: Speichereinrichtung
- 200: Laserdioden-Modul
- 210: Laserdiode
- 220: Temperatursensor
- 230: Sicherheitssensor
- 240: Sensor zum Erfassen des Lichtstroms
- 300: Scheinwerfer
- AS: Ausgangssignal
- ID: Diodenstrom
- S0: Steuersignal
- S1, ..., S3: Sensorsignal

## Patentansprüche

1. Steuervorrichtung zur Ansteuerung einer Laserdiode, umfassend:
- einen Ausgangsanschluss (A100) zum Anschließen der Laserdiode (210),
- eine Regelungseinrichtung (120) mit einem Anschluss (A120) zum Erzeugen einer Ausgangsspannung (AS),
- eine Detektoreinrichtung (130), die dazu ausgebildet ist, einen Ist-Pegel eines bei angeschlossener Laserdiode in Abhängigkeit von der Ausgangsspannung (AS) und einem Betriebszustand der Laserdiode durch die Laserdiode fließenden Diodenstroms (ID) der Laserdiode als Regelungsgröße zu ermitteln, wenn die Regelungseinrichtung (120) an dem Anschluss (A120) die Ausgangsspannung (AS) bereitstellt und an dem Ausgangsanschluss (A100) die Laserdiode angeschlossen ist,
- eine Rechnereinrichtung (110) zum Bereitstellen eines Steuersignals (S0) für die Regelungseinrichtung (120), wobei die Rechnereinrichtung (110) das Steuersignal unabhängig von der Regelungsgröße bereitstellt und das Steuersignal (S0) einen Soll-Pegel des Diodenstroms der Laserdiode angibt,
- wobei die Regelungseinrichtung (120) derart ausgebildet ist, dass sie in Abhängigkeit von dem Steuersignal (S0) und der ermittelten Regelungsgröße (ID) einen Pegel der Ausgangsspannung (AS) erzeugt,
- wobei die Detektoreinrichtung (130) zwischen dem Ausgangsanschluss (A100) und der Regelungseinrichtung (120) angeordnet ist,
- wobei die Steuervorrichtung (100) derart ausgebildet ist, dass das Erzeugen des Diodenstroms unterbrochen wird, wenn der Pegel des Diodenstroms (ID) einen Schwellwert überschreitet.

2. Steuervorrichtung nach Anspruch 1, umfassend:
- einen ersten Eingangsanschluss (E100a) zum Anschließen eines ersten Sensors (220), der zum Ermitteln einer Temperatur der Laserdiode (210) ausgebildet ist, wobei der erste Eingangsanschluss (E100a) zum Empfang eines von dem ersten Sensor (220) in Abhängigkeit von der ermittelten Temperatur der Laserdiode erzeugten ersten Sensorsignals (S1) ausgebildet ist,
- wobei die Rechnereinrichtung (110) derart ausgebildet ist, das Steuersignal (S0) in Abhängigkeit von dem ersten Sensorsignal (S1) zu erzeugen.

3. Steuervorrichtung nach einem der Ansprüche 1 oder 2, umfassend:
- einen zweiten Eingangsanschluss (E100b) zum Anschließen eines zweite Sensors (230), der zum Feststellen eines bestimmungsgemäßen oder fehlerbehafteten Betriebszustands der Laserdiode (210) ausgebildet ist, wobei der zweite Eingangsanschluss (E100b) zum Empfang eines von dem zweiten Sensor (230) in Abhängigkeit von dem festgestellten Betriebszustand der Laserdiode erzeugten zweiten Sensorsignals ausgebildet ist,
- wobei die Rechnereinrichtung (110) derart ausgebildet ist, das Steuersignal (S0) in Abhängigkeit von dem zweiten Sensorsignal (S2) zu erzeugen.

4. Steuervorrichtung nach einem der Ansprüche 1 bis 3, umfassend:
- einen dritten Eingangsanschluss (E100c) zum Anschließen eines dritten Sensors (240), der zum Erfassen des Lichtstroms der Laserdiode (210) ausgebildet ist, wobei der dritte Eingangsanschluss (E100c) zum Empfang eines von dem dritten Sensor (240) in Abhängigkeit von dem erfassten Lichtstrom der Laserdiode (210) erzeugten dritten Sensorsignals (S3) ausgebildet ist,
- wobei die Rechnereinrichtung (110) derart ausgebildet ist, das Steuersignal (S0) in Abhängigkeit von dem dritten Sensorsignal (S3) zu erzeugen.

5. Steuervorrichtung nach einem der Ansprüche 1 bis 4,
wobei die Detektoreinrichtung einen Widerstand (130) aufweist und die Regelungseinrichtung (120) dazu ausgebildet ist, den Ist-Pegel des Diodenstroms (ID) durch Auswerten der an dem Widerstand abfallenden Spannung zu ermitteln.

6. Steuervorrichtung nach einem der Ansprüche 1 bis 5,
wobei die Regelungseinrichtung (120) derart ausgebildet ist, das Erzeugen der Ausgangsspannung (AS) in Abhängigkeit von dem ermittelten Pegel des Steuersignals (S0) zu unterbrechen.

7. Steuervorrichtung nach einem der Ansprüche 1 bis 6, umfassend:
- einen Versorgungsspannungsanschluss (V100) zum Anlegen einer Versorgungsspannung (Vin),
- eine Filterschaltung (140, 150) zum Herausfiltern von transienten Spannungsänderungen der Versorgungsspannung (Vin) und zum Herausfiltern einer Strom- und Spannungswelligkeit an dem Ausgangsanschluss (A100).

8. Steuervorrichtung nach einem der Ansprüche 1 bis 7, umfassend:
- eine Speichereinrichtung (160) zum Speichern von leuchtmittelspezifischen Charakteristiken der an den Ausgangsanschluss anzuschließenden Laserdiode (210),
- wobei die Rechnereinrichtung (110) derart ausgebildet ist, das Steuersignal (S0) in Abhängigkeit von den leuchtmittelspezifischen Charakteristiken zu erzeugen.

9. Steuervorrichtung nach Anspruch 8,
- wobei in der Speichereinrichtung (160) eine Alterungs-Kennlinie, die einen Zusammenhang zwischen der Helligkeit der anzuschließenden Laserdiode und der Betriebsdauer der Laserdiode enthält, und/oder wobei in der Speichereinrichtung (160) mindestens ein Parameter, der eine Helligkeit- und/oder Farbsortierung der anzuschließenden Laserdiode enthält, gespeichert ist,
- wobei die Rechnereinrichtung (110) derart ausgebildet ist, das Steuersignal (S0) in Abhängigkeit von der Alterungs-Kennlinie und/oder in Abhängigkeit von dem mindestens einen Parameter zu erzeugen .

10. Beleuchtungsvorrichtung für ein Fahrzeug, umfassend:
- eine Steuervorrichtung (100) zur Ansteuerung einer Laserdiode (210) nach einem der Ansprüche 1 bis 9,
- die Laserdiode (201),
- wobei die Laserdiode (210) an den Ausgangsanschluss (A100) der Steuervorrichtung (100) angeschlossen ist.

11. Beleuchtungsvorrichtung für ein Fahrzeug nach Anspruch 10, umfassend:
- einen Temperatursensor (220) zum Ermitteln einer Temperatur der Laserdiode (210), der an den ersten Eingangsanschluss (E100a) der Steuervorrichtung angeschlossen ist, wobei der Temperatursensor (220) derart ausgebildet ist, das erste Sensorsignal (S1) in Abhängigkeit von der ermittelten Temperatur der Laserdiode zu erzeugen,
- wobei die Rechnereinrichtung (110) das Steuersignal (S0) derart erzeugt, dass die Regelungseinrichtung (120) das Erzeugen des Ausgangsignals (AS) unterbricht, wenn die Rechnereinrichtung (110) nach dem Auswerten des ersten Sensorsignals (S1) feststellt, dass die von dem Temperatursensor (220) ermittelte Temperatur der Laserdiode über einem Schwellwert liegt.

12. Beleuchtungsvorrichtung für ein Fahrzeug nach einem der Ansprüche 10 oder 11, umfassend:
- den zweiten Sensor (230) zum Feststellen eines bestimmungsgemäßen oder fehlerbehafteten Betriebszustands der Laserdiode (210), der an den zweiten Eingangsanschluss (E100b) der Steuervorrichtung (100) angeschlossen ist,
- wobei die Rechnereinrichtung (110) das Steuersignal (S0) derart erzeugt, dass die Regelungseinrichtung (120) das Erzeugen der Ausgangsspannung (AS) unterbricht, wenn die Rechnereinrichtung (110) nach dem Auswerten des zweiten Sensorsignals (S2) feststellt, dass die Laserdiode den fehlerhaften Betriebszustand aufweist.

13. Beleuchtungsvorrichtung für ein Fahrzeug nach einem der Ansprüche 10 bis 12, umfassend:
- den dritten Sensor (240) zum Erfassen des Lichtstroms der Laserdiode (210), der an den dritten Eingangsanschluss (E100c) der Steuervorrichtung (100) angeschlossen ist,
- wobei die Rechnereinrichtung (110) das Steuersignal (S0) derart erzeugt, dass die Regelungseinrichtung (120) das Erzeugen der Ausgangsspannung (AS) unterbricht, wenn die Rechnereinrichtung (110) nach dem Auswerten des dritten Sensorsignals (S3) feststellt, dass der von der Laserdiode (210) erzeugte Lichtstrom über oder unter einem Grenzwert liegt und/oder die spektrale Zusammensetzung des von der Laserdiode emittierten Lichts sich in einen unzulässigen Bereich befindet.

14. Fahrzeug, umfassend:
eine Beleuchtungsvorrichtung (10) für das Fahrzeug (1) nach einem der Ansprüche 10 bis 13.

## Claims

1. Control apparatus for driving a laser diode, comprising:
- an output terminal (A100) for connecting the laser diode (210),
- a regulation device (120) with a terminal (A120) for generating an output voltage (AS),
- a detector device (130) configured to determine an actual level of a diode current (ID) of the laser diode as a regulation variable, said diode current flowing through the laser diode when the laser diode is connected depending on the output voltage (AS) and an operating state of the laser diode, when the regulation device (120) provides the output voltage (AS) at the terminal (A120) and the laser diode is connected to the output terminal (A100),
- a computer device (110) for providing a control signal (S0) for the regulation device (120), wherein the computer device (110) provides the control signal independently of the regulation variable and the control signal (S0) specifies a target level of the diode current of the laser diode,
- wherein the regulation device (120) is configured in such a way that it generates a level of the output voltage (AS) depending on the control signal (S0) and the determined regulation variable (ID),
- wherein the detector device (130) is arranged between the output terminal (A100) and the regulation device (120),
- wherein the control apparatus (100) is configured in such a way that the generation of the diode current is interrupted if the level of the diode current (ID) exceeds a threshold value.

2. Control apparatus according to Claim 1, comprising:
- a first input terminal (E100a) for connecting a first sensor (220), which is configured for determining a temperature of the laser diode (210), wherein the first input terminal (E100a) is configured for receiving a first sensor signal (S1) generated by the first sensor (220) depending on the determined temperature of the laser diode,
- wherein the computer device (110) is configured so as to generate the control signal (S0) depending on the first sensor signal (S1).

3. Control apparatus according to either of Claims 1 and 2, comprising:
- a second input terminal (E100b) for connecting a second sensor (230) configured for ascertaining a proper or erroneous operating state of the laser diode (210), wherein the second input terminal (E100b) is configured for receiving a second sensor signal generated by the second sensor (230) depending on the ascertained operating state of the laser diode,
- wherein the computer device (110) is configured so as to generate the control signal (S0) depending on the second sensor signal (S2).

4. Control apparatus according to any of Claims 1 to 3, comprising:
- a third input terminal (E100c) for connecting a third sensor (240) configured for sensing the luminous flux of the laser diode (210), wherein the third input terminal (E100c) is configured for receiving a third sensor signal (S3) generated by the third sensor (240) depending on the sensed luminous flux of the laser diode (210),
- wherein the computer device (110) is configured so as to generate the control signal (S0) depending on the third sensor signal (S3).

5. Control apparatus according to any of Claims 1 to 4, wherein the detector device has a resistor (130) and the regulation device (120) is configured to determine the actual level of the diode current (ID) by evaluating the voltage dropped across the resistor.

6. Control apparatus according to any of Claims 1 to 5, wherein the regulation device (120) is configured so as to interrupt the generation of the output voltage (AS) depending on the determined level of the control signal (S0) .

7. Control apparatus according to any of Claims 1 to 6, comprising:
- a supply voltage terminal (V100) for applying a supply voltage (Vin),
- a filter circuit (140, 150) for filtering out transient voltage changes of the supply voltage (Vin) and for filtering out a current and voltage ripple at the output terminal (A100).

8. Control apparatus according to any of Claims 1 to 7, comprising:
- a storage device (160) for storing illuminant-specific characteristics of the laser diode (210) to be connected to the output terminal,
- wherein the computer device (110) is configured so as to generate the control signal (S0) depending on the illuminant-specific characteristics.

9. Control apparatus according to Claim 8,
- wherein an ageing characteristic curve containing a relationship between the brightness of the laser diode to be connected and the operating time of the laser diode is stored in the storage device (160), and/or wherein at least one parameter containing a brightness and/or colour sorting of the laser diode to be connected is stored in the storage device (160),
- wherein the computer device (110) is configured so as to generate the control signal (S0) depending on the ageing characteristic curve and/or depending on the at least one parameter.

10. Lighting apparatus for a vehicle, comprising:
- a control apparatus (100) for driving a laser diode (210) according to any of Claims 1 to 9,
- the laser diode (201),
- wherein the laser diode (210) is connected to the output terminal (A100) of the control apparatus (100).

11. Lighting apparatus for a vehicle according to Claim 10, comprising:
- a temperature sensor (220) for determining a temperature of the laser diode (210), said temperature sensor being connected to the first input terminal (E100a) of the control apparatus, wherein the temperature sensor (220) is configured so as to generate the first sensor signal (S1) depending on the determined temperature of the laser diode,
- wherein the computer device (110) generates the control signal (S0) in such a way that the regulation device (120) interrupts the generation of the output signal (AS) if, after the evaluation of the first sensor signal (S1), the computer device (110) ascertains that the temperature of the laser diode determined by the temperature sensor (220) lies above a threshold value.

12. Lighting apparatus for a vehicle according to either of Claims 10 and 11, comprising:
- the second sensor (230) for ascertaining a proper or erroneous operating state of the laser diode (210), said second sensor being connected to the second input terminal (E100b) of the control apparatus (100),
- wherein the computer device (110) generates the control signal (S0) in such a way that the regulation device (120) interrupts the generation of the output voltage (AS) if, after the evaluation of the second sensor signal (S2), the computer device (110) ascertains that the laser diode has the erroneous operating state.

13. Lighting apparatus for a vehicle according to any of Claims 10 to 12, comprising:
- the third sensor (240) for sensing the luminous flux of the laser diode (210), said third sensor being connected to the third input terminal (E100c) of the control apparatus (100),
- wherein the computer device (110) generates the control signal (S0) in such a way that the regulation device (120) interrupts the generation of the output voltage (AS) if, after the evaluation of the third sensor signal (S3), the computer device (110) ascertains that the luminous flux generated by the laser diode (210) lies above or below a limit value and/or the spectral composition of the light emitted by the laser diode is in an impermissible range.

14. Vehicle, comprising:
a lighting apparatus (10) for the vehicle (1) according to any of Claims 10 to 13.

## Revendications

1. Dispositif de commande permettant d'exciter une diode laser, comprenant :
- une borne de sortie (A100) pour connecter la diode laser (210),
- un système de régulation (120) pourvu d'une borne (A120) pour générer une tension de sortie (AS),
- un système de détection (130) qui est réalisé pour déterminer comme grandeur de régulation un niveau réel d'un courant de diode (ID) de la diode laser passant à travers la diode laser lorsque la diode laser est connectée, en fonction de la tension de sortie (AS) et d'un état de fonctionnement de la diode laser, lorsque le système de régulation (120) fournit la tension de sortie (AS) au niveau de la borne (A120) et la diode laser est connectée à la borne de sortie (A100),
- un système de calcul (110) servant à fournir un signal de commande (S0) pour le système de régulation (120), le système de calcul (110) fournissant le signal de commande indépendamment de la grandeur de régulation et le signal de commande (S0) indiquant un niveau de consigne du courant de diode de la diode laser,
- dans lequel le système de régulation (120) est réalisé de telle sorte qu'il génère un niveau de la tension de sortie (AS) en fonction du signal de commande (S0) et de la grandeur de régulation (ID) déterminée,
- dans lequel le système de détection (130) est disposé entre la borne de sortie (A100) et le système de régulation (120),
- dans lequel le dispositif de commande (100) est réalisé de telle sorte que la génération du courant de diode est interrompue lorsque le niveau du courant de diode (ID) dépasse une valeur seuil.

2. Dispositif de commande selon la revendication 1, comprenant :
- une première borne d'entrée (E100a) pour connecter un premier capteur (220) qui est réalisé pour déterminer une température de la diode laser (210), la première borne d'entrée (E100a) étant réalisée pour recevoir un premier signal de capteur (S1) généré par le premier capteur (220) en fonction de la température déterminée de la diode laser,
- dans lequel le système de calcul (110) est réalisé de façon à générer le signal de commande (S0) en fonction du premier signal de capteur (S1).

3. Dispositif de commande selon l'une quelconque des revendications 1 ou 2, comprenant :
- une deuxième borne d'entrée (E100b) pour connecter un deuxième capteur (230) qui est réalisé pour constater un état de fonctionnement correct ou incorrect de la diode laser (210), la deuxième borne d'entrée (E100b) étant réalisée pour recevoir un deuxième signal de capteur généré par le deuxième capteur (230) en fonction de l'état de fonctionnement constaté de la diode laser,
- dans lequel le système de calcul (110) est réalisé de façon à générer le signal de commande (S0) en fonction du deuxième signal de capteur (S2).

4. Dispositif de commande selon l'une quelconque des revendications 1 à 3, comprenant :
- une troisième borne d'entrée (E100c) pour connecter un troisième capteur (240) qui est réalisé pour détecter le flux lumineux de la diode laser (210), la troisième borne d'entrée (E100c) étant réalisée pour recevoir un troisième signal de capteur (S3) généré par le troisième capteur (240) en fonction du flux lumineux détecté de la diode laser (210),
- dans lequel le système de calcul (110) est réalisé de façon à générer le signal de commande (S0) en fonction du troisième signal de capteur (S3).

5. Dispositif de commande selon l'une quelconque des revendications 1 à 4, dans lequel le système de détection présente une résistance (130), et le système de régulation (120) est réalisé pour déterminer le niveau réel du courant de diode (ID) par l'évaluation de la tension chutant au niveau de la résistance.

6. Dispositif de commande selon l'une quelconque des revendications 1 à 5, dans lequel le système de régulation (120) est réalisé de façon à interrompre la génération de la tension de sortie (AS) en fonction du niveau déterminé du signal de commande (S0).

7. Dispositif de commande selon l'une quelconque des revendications 1 à 6, comprenant :
- une borne de tension d'alimentation (V100) pour appliquer une tension d'alimentation (Vin),
- un circuit de filtrage (140, 150) pour éliminer par filtrage des variations de tension transitoires de la tension d'alimentation (Vin) et pour éliminer par filtrage une ondulation de courant et de tension au niveau de la borne de sortie (A100).

8. Dispositif de commande selon l'une quelconque des revendications 1 à 7, comprenant :
- un système de mémoire (160) pour mémoriser des caractéristiques spécifiques à des moyens d'éclairage de la diode laser (210) à connecter à la borne de sortie,
- dans lequel le système de calcul (110) est réalisé de façon à générer le signal de commande (S0) en fonction des caractéristiques spécifiques aux moyens d'éclairage.

9. Dispositif de commande selon la revendication 8,
- dans lequel une courbe caractéristique de vieillissement est mémorisée dans le système de mémoire (160), qui comprend une relation entre la luminosité de la diode laser à connecter et la durée de fonctionnement de la diode laser, et/ou dans lequel au moins un paramètre est mémorisé dans le système de mémoire (160), qui comprend un tri par luminosité et/ou par couleur de la diode laser à connecter,
- dans lequel le système de calcul (110) est réalisé de façon à générer le signal de commande (S0) en fonction de la courbe caractéristique de vieillissement et/ou en fonction du au moins un paramètre.

10. Dispositif d'éclairage pour un véhicule, comprenant :
- un dispositif de commande (100) pour exciter une diode laser (210) selon l'une quelconque des revendications 1 à 9,
- la diode laser (201),
- dans lequel la diode laser (210) est connectée à la borne de sortie (A100) du dispositif de commande (100) .

11. Dispositif d'éclairage pour un véhicule selon la revendication 10, comprenant :
- un capteur de température (220) pour déterminer une température de la diode laser (210) qui est connectée à la première borne d'entrée (E100a) du dispositif de commande, le capteur de température (220) étant réalisé de façon à générer le premier signal de capteur (S1) en fonction de la température déterminée de la diode laser,
- dans lequel le système de calcul (110) génère le signal de commande (S0) de telle sorte que le système de régulation (120) interrompt la génération du signal de sortie (AS) si le système de calcul (110) constate après l'évaluation du premier signal de capteur (S1) que la température de la diode laser, déterminée par le capteur de température (220), est supérieure à une valeur seuil.

12. Dispositif d'éclairage pour un véhicule selon l'une quelconque des revendications 10 ou 11, comprenant :
- le deuxième capteur (230) pour constater un état de fonctionnement correct ou incorrect de la diode laser (210) qui est connectée à la deuxième borne d'entrée (E100b) du dispositif de commande (100),
- dans lequel le système de calcul (110) génère le signal de commande (S0) de telle sorte que le système de régulation (120) interrompt la génération de la tension de sortie (AS) si le système de calcul (110) constate après l'évaluation du deuxième signal de capteur (S2) que la diode laser présente l'état de fonctionnement incorrect.

13. Dispositif d'éclairage pour un véhicule selon l'une quelconque des revendications 10 à 12, comprenant :
- le troisième capteur (240) pour détecter le flux lumineux de la diode laser (210) qui est connectée à la troisième borne d'entrée (E100c) du dispositif de commande (100),
- dans lequel le système de calcul (110) génère le signal de commande (S0) de telle sorte que le système de régulation (120) interrompt la génération de la tension de sortie (AS) si le système de calcul (110) constate après l'évaluation du troisième signal de capteur (S3) que le flux lumineux généré par la diode laser (210) se situe au-dessus ou au-dessous d'une valeur limite et/ou que la composition spectrale de la lumière émise par la diode laser se trouve dans une plage inadmissible.

14. Véhicule, comprenant :
un dispositif d'éclairage (10) destiné au véhicule (1) selon l'une quelconque des revendications 10 à 13.
